# EUROPEAN PATENT APPLICATION

(11) **EP 4 517 360 A1**
(43) Date of publication of application: **05.03.2025**
(21) Application number: 23195170.8
(22) Date of filing: 04.09.2023
(51) Int. Cl.: G01R 33/563, G01R 33/56, G01R 33/561

(54) **RECONSTRUCTION NETWORK AND METHOD FOR RECONSTRUCTING CINE MRI IMAGES**

(71) Applicant: Siemens Healthineers AG, 91301 Forchheim (DE); Friedrich-Alexander-Universität Erlangen-Nürnberg, 91054 Erlangen (DE)
(72) Inventor: Giese, Daniel, 91052 Erlangen (DE); Knoll, Florian, 91054 Erlangen (DE); Vornehm, Marc, 91054 Erlangen (DE); Wetzl, Jens, 91056 Erlangen (DE)
(74) Representative: Siemens Healthineers Patent Attorneys

(57) **Abstract**

The invention describes a reconstruction network (12) for reconstructing cine MRI images, the reconstruction network (12) being a variational network designed for reconstructing images from cine MRI data and comprising an architecture with a cascade of cascade-modules (C1, C2, C3), wherein the input of the first cascade-module (C1, C2, C3) is an input-stack (S) of a plurality of N frames (K1, K2, K, K4) and the input of each following cascade-module (C1, C2, C3) is the input-stack (S) and an output-stack (P, P') of the preceding cascade-module (C1, C2), wherein the reconstruction network (12) comprises a selection-unit (U) designed to select one single frame (F) being processed by the cascade-modules (C1, C2, C3) that corresponds to the i-th frame of the input stack (S) for being the basis for the output dataset. The invention further describes a reconstruction method, a training method and a related magnetic resonance imaging system.

## Description

The invention describes a reconstruction network and a reconstruction-method for reconstructing cine MRI images, as well as training-method for training the reconstruction network and an MRI-System. Especially the invention pertains to low-latency deep learning-based reconstruction of interactive real-time (preferably cardiac) cine MRI.

Cine MRI, also known as "cine sequences" or "cine imaging", is a type of MRI recording to capture motion. Cine images are acquired by repeatedly imaging an area of interest for a certain period of time. Typically, a single slice is recorded, although it is also possible to record 3D images.

Cine MRI is often used for cardiac imaging. Interactive cardiac MRI is commonly used for real-time diagnostic as well as interventional applications and poses unique requirements on reconstruction latency, i.e. the time between acquisition and image display.

For device navigation, for instance, a maximum latency of 200 ms is considered tolerable. Achieving the desired spatial and temporal resolution often requires high acceleration rates, which, in turn, call for sophisticated and time-consuming reconstruction techniques.

It is the object of the present invention to improve the known systems and methods to facilitate an improvement in reconstructing cine MRI images with a trained (machine learning) reconstruction network. Especially it is an object of the invention to provide a solution for low-latency deep learning-based reconstruction of interactive real-time (preferably cardiac) cine MRI.

This object is achieved by a reconstruction network according to claim 1, a reconstruction-method according to claim 5, a training-method according to claim 6 and an MRI-System according to claim 12.

A (machine learning) reconstruction network according to the invention for reconstructing cine MRI images is a variational network designed for reconstructing images from cine MRI data and comprising an architecture with a cascade of (especially serially arranged) cascade-modules. Each cascade module resembles one update step in an iterative gradient descent-based reconstruction. The input of the first cascade-module is an input-stack of a plurality of N frames and the input of each following cascade-module is the input-stack and an output-stack of the preceding cascade-module. The reconstruction network (additionally) comprises a selection-unit designed to select one single frame being processed by the cascade-modules that corresponds to the i-th frame of the input stack for being the basis for the output dataset (reconstructed images or frames in k-space).

The general architecture of a variational network as well as suitable training procedures are well known in the art. The reconstruction network according to the invention must be able to reconstruct cine MRI images, i.e. images from undersampled MRI-datasets (being k-space frames). The internal architecture of the reconstruction network is a cascade of cascade-modules that are serially arranged (the input of each following cascade-module is the output-stack of the preceding cascade-module). Thus, each cascade module resembles one update step in an iterative gradient descent-based reconstruction. The input of the first cascade-module is an input-stack of a plurality of N (k-space) frames.

Preferably, the number of serially arranged cascade-modules lies between 2 and 20, especially between 5 and 10. More cascade-modules may improve reconstruction quality, but also increase reconstruction time. The inventors found out that increasing the model complexity beyond 6-8 cascade-modules does not substantially improve image quality.

The input of each cascade-module is preferably also coil sensitivity maps. The cascade modules may have identical internal architectures, but different weighting factors and/or computing parameters.

One very important feature of the reconstruction network according to the invention is the selection-unit that is designed to select one single frame (being an output of the last cascade) that corresponds to the i-th frame of the input stack. This means that the selected frame is different to the inputted frames, since it has been processed by the cascade, but is has always the same position concerning the input-stack (e.g. always the last frame).

This frame is then the basis for the output dataset. The output dataset may comprise reconstructed images and/or frames in k-space. Since the variational network could use image information of the whole stack of frames, showing a scene, e.g. such as a beating heart, the quality of the single frame and, thus, also the quality of an image reconstructed from that single frame is enhanced by reconstruction network.

A reconstruction-method according to the invention for reconstructing cine MRI images with a reconstruction network according to the invention comprising the following steps:
a) recording a plurality of MRI dataframes from a region of interest at different points of time, especially from a heart,
b) form an input stack from the temporally last recorded plurality of N MRI dataframes,
c) inputting the input-stack into the reconstruction network and reconstructing an image from one single frame chosen by the selection-unit of the reconstruction network (i.e. processed by the cascade modules of the reconstruction network and corresponding to the i-th frame of the input stack),
d) displaying the image,
e) in the case there is another recorded MRI dataframe, repeating the steps b) to e) until a termination condition is reached.

The recording of a plurality of MRI dataframes from a region of interest at different points of time is well known. Usually (at least in cine MRI), these datasets are under-sampled in order to record datasets fast enough to show a moving ROI (a video). The reconstruction-method is especially advantageous for cardiac MRI.

The input stack is formed in a similar manner as explained above for the training-frames. In order to have a small latency, the input stack should be selected from the temporally last recorded N MRI dataframes. The number of frames of the input stack should be the same as the number of training-frames, since the reconstruction network has been trained for this very number.

This input stack could simply be inputted into a (trained) reconstruction network that will reconstruct an image from a single frame of the input stack automatically, and this image can then be displayed.

In order to produce a video, every time there is another recorded MRI dataframe, there could be generated a new stack for every repetition or the oldest frame could be deleted a one end and the newest frame could be added to the other end of this stack. With the new input frames, a new image could be reconstructed. Displaying the reconstructed images will result in a video. Since the time for reconstruction is very short, the video shows the recorded ROI nearly in real time.

A training-method according to the invention is able to train a (machine learning) reconstruction network according to the invention for reconstructing cine MRI images. The reconstruction network is preferably a deep machine learning network and the training-method is then a deep learning-based method for real-time reconstruction of (especially cardiac) cine MRI. Its goal is to reduce reconstruction latency and enhance image quality, especially to assess its feasibility for interactive real-time (IRT) MRI applications. The training-method comprises the following steps:
a) recording a plurality of MRI dataframes in a time period, wherein the MRI dataframes show a region of interest at different points of time,
b) selecting a subset of N training-frames consecutive in time from the MRI dataframes as input-stack,
c) inputting the subset of training-frames into the reconstruction network and generating an output dataset based on one single frame chosen by the selection-unit of the reconstruction network (i.e. a frame processed by the cascade modules of the reconstruction network and corresponding to the i-th frame of the input stack),
d) computing the loss based on the output dataset and update the parameters of the reconstruction network based on this loss,
e) selecting a further subset of N training-frames consecutive in time from the MRI dataframes,
f) repeating the steps c) to f) until a termination condition is reached.

Variational Networks are well known and actually used for reconstructing images from MRI dataframes. Since the technical field is cine MRI, these MRI dataframes are datasets of an MRI recording taken at certain points in time. Although a frame may comprise data from a 3D-area, it is often just data from a slice of the region of interest (ROI).

Thus, each MRI dataframe could be imagined as k-space data which (when an image would be reconstructed from it) shows at least a slice of the ROI. Now, many frames are recorded in a time period, wherein every frame could be imagined as representing a slice. Since the region of interest may change in time, it is not necessary that all frames represent the same position of a slice in patient. However, they always represent a part of the recorded region. For example, the frames may "show" (they are in k-space) a beating heart, wherein every frame "shows" another state of the heartbeat. The frames may also follow the path of an instrument "showing" different slices of the patient depending on where the tip of the instrument is positioned at a point in time. Thus, the MRI dataframes could be imagined (when reconstructed) as a movie of a region of interest (e.g. a certain slice of the heart).

After the MRI dataframes are recorded, the subset of N training-frames is selected from these MRI dataframes. The training-frames must be consecutive in time (i.e. a series of temporally adjacent dataframes), but it is not necessary that they comprise the newest or oldest MRI dataframe. Usually, not all MRI dataframes are fetched, but only a (small) part (N is preferably smaller than the total number of MRI dataframes. It is not necessary to stop the recording of MRI dataframes for this step.

These training-frames are then inputted into the reconstruction network and an output dataset is generated. This output dataset could be an image reconstructed from one single frame selected by the selection-unit (then the loss is calculated based on that image). The output dataset could also be the selected single training-frame (then the loss could be calculated directly in k-space).

It should be noted that it is not necessary to reconstruct other images or to select other single frames, since the aim of the training-method is to get optimal data for one single frame for each input stack.

It is preferred that the relative position of the selected single frame stays the same for all sets of training-frames during the training. The selected single frame may correspond to the last of the N training-frames, but could also correspond to the second last or the third last. The position of the selected single frame could be selected depending on the latency that is tolerated. When there are some frames following the selected single frame, "future" states could be regarded to enhance accuracy of the reconstruction (there are some frames "showing" the past and some "showing" the future of the selected training-frame). On the other hand, when the last frame is selected as single frame, the latency will be minimal. Since in typical applications, the latency could be about 200 ms, it could be advantageous, to select a single frame that is temporally positioned in the last 200 ms of the N training-frames. In short: By delaying the reconstruction by one frame or two, the network can incorporate future information, which further improves image quality at the expense of increased reconstruction latency.

Based on the output dataset (this single frame or an image reconstructed from it), the loss of this image is calculated and the parameters of the reconstruction network are updated based on this loss (i.e. the loss is propagated back into the network). The construction of such loss as well in image space as in k-space, and the updating of parameters is well known in the art and belongs to a typical training procedure. However, in this training-method, the loss is calculated (exclusively) based on the single frame (e.g. from this very frame or an image reconstructed from that frame) and not on a plurality of frames.

As said above, a typical variational network comprises several cascades of machine networks, e.g. a convolutional Network combined with a consistency module. The goal of the training is to find an optimal parameter set of these cascades that may have an identical architecture, but different parametervalues. Typically, a loss function has to be minimized over the single image with respect to the parameters. The loss function typically defines the similarity between the reconstructed image and a reference image that should have a good quality. For example, the data used to generate the training data could be normally recorded MRI-data of good quality (for training the recording time is not crucial). The reference image could be reconstructed from this "good" data. The training-datasets could now be undersampled sets of this "good" data. Then, there is a clean, artifact-free reference image. The loss function could be the mean-squared error (MSE-loss), the SSIM-Loss (SSIM for "structural similarity index measure") or the so called "⊥-loss" the symmetric loss function for magnetic resonance imaging reconstruction and image registration with deep learning.

Since the complete training-dataset is inputted into the variational network, information of all frames are present in a single frame outputted by the variational network. One could say that a frame is ameliorated with the information of the preceding and possibly following frames. Thus, the quality of the single frame selected is better than the quality of the respective training-frame of the inputted training dataset. The feature that the output dataset is based on a single frame selected from the subset of training-frames, therefore means that one frame at a defined position of the stack of frames of the training-dataset is chosen. The respective single frame of the outputted stack is then chosen as output dataset. Although this single frame corresponds to the inputted training-frame (i.e. shows the same object at the same time, e.g. the same phase of a heartbeat) it comprises information of the whole stack of the inputted training-dataset.

Then, a further subset of N training-frames is selected and the training is continued. It is especially possible to record MRI datasets over a (long) time period and always replace the oldest training-frame deleted at the "past temporal end" of the N training-frames by the newest MRI dataframe copied at the "future temporal end" of the N training-frames.

It should be noted that in the case where the loss is computed directly in k-space, the reconstruction network does not need to directly reconstruct images during training. It is not necessary that the reconstruction module of the reconstruction network is trained, since a known reconstruction module for the last image could be used. However, when the loss is calculated from a reconstructed image, the reconstruction module is already there.

In easy words, the reconstruction network is trained to output a video stream from an acquired MRI dataset. When using a temporally sliding window for selecting a subset of N frames from recorded MRI data, the reconstructed (single) images would show a moving scene. Due to the training the reconstruction can be optimized even if the MRI dataset is undersampled (see further description).

Especially this trained reconstruction network is advantageous for the reconstruction of interactive real-time (IRT) cardiac cine MRI. Its performance in terms of reconstruction time and quality is evaluated in the described "retrospective simulation" of an IRT scenario that would require low reconstruction latencies due to the trained network that could provide an output in a very short time.

It should be noted that for training this "sliding window" is not absolutely necessary, since the reconstruction works for single images.

An MRI-System according to the invention comprises a reconstruction network according to the invention especially trained by a training-method according to the invention.

It should be noted that a reconstruction network is preferably trained with the selection unit adjusted to select the single frame always with the same position (the i-th) corresponding to the frames of the input stack. However, when a video with more or less latency is desired, the position of the selected frame has to be changed. Looking at these specially trained reconstruction networks it is preferred that there are multiple reconstruction networks all been trained for a different position of the selected single frame. For this embodiment, the MRI-system preferably comprises means for controlling the selection unit or for choosing a reconstruction network.

The control of the selection unit may be a control at the beginning of training. The position of the single frame could be selected. After the selection it is preferred that the selected position is not changeable any more for this reconstruction network (e.g. written in a EPROM).

A preferred embodiment of the MRI-System, comprises multiple reconstruction networks according to the invention with selection units designed to select single frames at different positions of processed stacks, wherein each reconstruction network comprises a selection unit selecting single frames at an individual constant position of processed stacks (not changeable, always stays the same).

It is preferred that the MRI-System additionally comprises a user interface designed such that a user is able to choose between the positions of the selected single frames, especially by choosing between given positions or between given latency times.

Some units or modules of the invention mentioned above can be completely or partially realized as software modules running on a processor of a computing system. A realization largely in the form of software modules can have the advantage that applications already installed on an existing computing system can be updated, with relatively little effort, to install and run these units of the present application. The object of the invention is also achieved by a computer program product with a computer program that is directly loadable into the memory of a computing system, and which comprises program units to perform the steps of the methods, at least those steps that could be executed by a computer, when the program is executed by the computing system. In addition to the computer program, such a computer program product can also comprise further parts such as documentation and/or additional components, also hardware components such as a hardware key (dongle etc.) to facilitate access to the software.

A computer readable medium such as a memory stick, a harddisk or other transportable or permanently-installed carrier can serve to transport and/or to store the executable parts of the computer program product so that these can be read from a processor unit of a computing system. A processor unit can comprise one or more microprocessors or their equivalents.

Particularly advantageous embodiments and features of the invention are given by the dependent claims, as revealed in the following description. Features of different claim categories may be combined as appropriate to give further embodiments not described herein.

According to a preferred reconstruction network, a (especially each) cascade-module comprises a convolutional neural network (CNN) designed to create output images from input images, especially a U-net or a V-net (in an arrangement where images are reconstructed from the processed frames as input images for the CNN). These images are processed by the convolutional neural network, especially by using a temporal and/or spatial convolution, and are converted into k-space frames afterwards. Temporal convolutions or combined temporal/spatial convolutions are advantageous, since they enable the use of data redundancy in the frames. Since input and output are in k-space, the architecture of a cascade module is such that a reconstruction module (k-space to image) is followed by the convolutional neural network that is again followed by an inverted reconstruction module (image to k-space).

Preferably, a (especially each) cascade-module additionally comprises a data consistency module working parallel to the convolutional neural network, wherein the outputs of the consistency module and the convolutional neural network are combined, especially together with the input.

A preferred reconstruction network comprises an image reconstruction-module, arranged to receive the selected single frame of the selection unit and reconstructing an image based on the selected single frame. It should be noted that the selected single frame is a frame processed by the cascade-modules of the reconstruction network.

A preferred reconstruction network comprises a loss-module arranged to receive the selected single frame of the selection unit and a reference frame (e.g. a high-quality frame of the scene shown by the selected single frame) and calculating a loss. This loss is based on a comparison between data based on the selected single frame and on the reference frame.

A preferred reconstruction network is especially trained by the method explained above. This means that the reconstruction network is trained according to the following steps:
a) recording a plurality of MRI dataframes in a time period, wherein the MRI dataframes show a region of interest at different points of time,
b) selecting a subset of N training-frames consecutive in time from the MRI dataframes as input-stack,
c) inputting the subset of training-frames into the reconstruction network and generating an output dataset based on one single frame chosen by the selection-unit of the reconstruction network (i.e. processed by the cascade and corresponding to the i-th frame of the input stack),
d) computing the loss based on the output dataset and update the parameters of the reconstruction network based on this loss,
e) selecting a further subset of N training-frames consecutive in time from the MRI dataframes,
f) repeating the steps c) to f) until a termination condition is reached.

According to a preferred training-method, the MRI dataframes are under-sampled by a predefined factor F (e.g. 8-fold) and the subset of training-frames is selected from the undersampled MRI dataframes. Since for training, a fast data acquisition is not crucial, "full" data could be acquired for the MRI dataframes and for generating training data, these "full" data frames could be under-sampled in order to simulate cine-MRI data. This has the advantage that the original not-under-sampled MRI dataframes (showing accurate images when reconstructed) could be used for a supervised training. It is preferred that a temporally varying under-sampling pattern is used for each frame. This is advantageous in order to simulate fluctuations in the acquired data.

According to a preferred training-method, for the subset of N training-frames, N is bigger than 4 and/or less than 30, preferably wherein N is chosen between 7 and 14. This has been shown a good trade-off between reconstruction accuracy and time used for this reconstruction.

According to a preferred training-method, the time difference between consecutive MRI dataframes is constant over the MRI data (i.e. the temporal resolution is constant) and preferably less than 1/10 second, especially less than 1/20 second. This allows a good temporal resolution. Alternatively or additionally, a predefined data sampling pattern allows combining data with different temporal resolutions, especially radial or spiral golden angle.

According to a preferred training-method, every selected single frame has the same relative position in the respective subset of N training-frames. This means that always e.g. the last frame is selected or the i-th last in the case some "future" frames should optimize the quality of the selected frame. Preferably, a frame from the temporally last third of the subset of N training-frames is selected, wherein it is preferred that there are not more than 5 frames temporally following the selected single frame, especially wherein the selected single frame temporally corresponds to the newest (last) frame in the subsample. As said above, by delaying the reconstruction by one frame or two, the network can incorporate future information, which further improves image quality at the expense of increased reconstruction latency.

According to a preferred training-method, the first selected subset of training-frames starts with a frame of the MRI dataframes, and following subsets of N training-frames start with the second frame of the respective preceding subset of training-frames. Thus, preferably the subset of N training-frames is selected by a temporally sliding window.

According to a preferred training-method, the reconstruction unit comprises a reconstruction module designed to reconstruct an image from the selected single frame, wherein the loss is computed based on a comparison between a reconstructed image of the MRI dataframes and the image reconstructed based on a respective selected single frame. As said above, the loss could be computed in k-space, however, to compute the loss in image-space could be advantageous. Here it should be noted that the information of the training-frames is changed during the propagation through the reconstruction network. Thus, the data used for reconstructing an image is not identical to the originally inputted training-frame however, the data nevertheless represents the respective selected single frame and is based on this frame.

It is preferred to calculate MSE-loss, SSIM-loss or so called "⊥-loss", wherein a combination of SSIM-loss and ⊥-loss is preferred. MSE loss, referring to the mean squared error and the SSIM-Loss (SSIM for "structural similarity index measure") are well known in the art. Also, the symmetric loss function for magnetic resonance imaging reconstruction and image registration with deep learning ("⊥-Loss") is well known.

In a preferred embodiment of the invention, components of the reconstruction network are part of a data-network, wherein preferably the data-network and an MRI-System which provides image data) are in data-communication with each other, wherein the data-network preferably comprises parts of the internet and/or a cloud-based computing system, wherein preferably the reconstruction network is realized in this cloud-based computing system. For example, the components of the system are part of a data-network, wherein preferably the data-network and a medical imaging system which provides the image data are in communication with each other. Such a networked solution could be implemented via an internet platform and/or in a cloud-based computing system.

The methods may also include elements of "cloud computing". In the technical field of "cloud computing", an IT infrastructure is provided over a data-network, e.g. a storage space or processing power and/or application software. The communication between the user and the "cloud" is achieved by means of data interfaces and/or data transmission protocols.

In the context of "cloud computing", in a preferred embodiment of the methods according to the invention, provision of data via a data channel (for example a data-network) to a "cloud" takes place. This "cloud" includes a (remote) computing system, e.g. a computer cluster that typically does not include the user's local machine. This cloud can be made available in particular by the medical facility, which also provides the medical imaging systems. In particular, the image acquisition data is sent to a (remote) computer system (the "cloud") via a RIS (Radiology Information System) or a PACS (Picture Archiving and Communication System).

The training-method according to the invention enables a training of a neural network for reconstruction of interactive real-time (especially cardiac) cine MRI, especially optimized regarding latency and image quality. A trained reconstruction model according to the invention achieves good reconstruction results with little temporal blurring.

Other objects and features of the present invention will become apparent from the following detailed descriptions considered in conjunction with the accompanying drawings. It is to be understood, however, that the drawings are designed solely for the purposes of illustration and not as a definition of the limits of the invention.
Figure 1 shows a simplified MRI system according to an embodiment of the invention.
Figure 2 shows a training procedure of the state of the art.
Figure 3 shows a reconstruction procedure of the state of the art,
Figure 4 shows a reconstruction procedure of the state of the art.
Figure 5 shows a training-method as well as a reconstruction-method according to the invention.
Figure 6 shows a reconstruction network according to the invention.

In the diagrams, like numbers refer to like objects throughout. Objects in the diagrams are not necessarily drawn to scale.

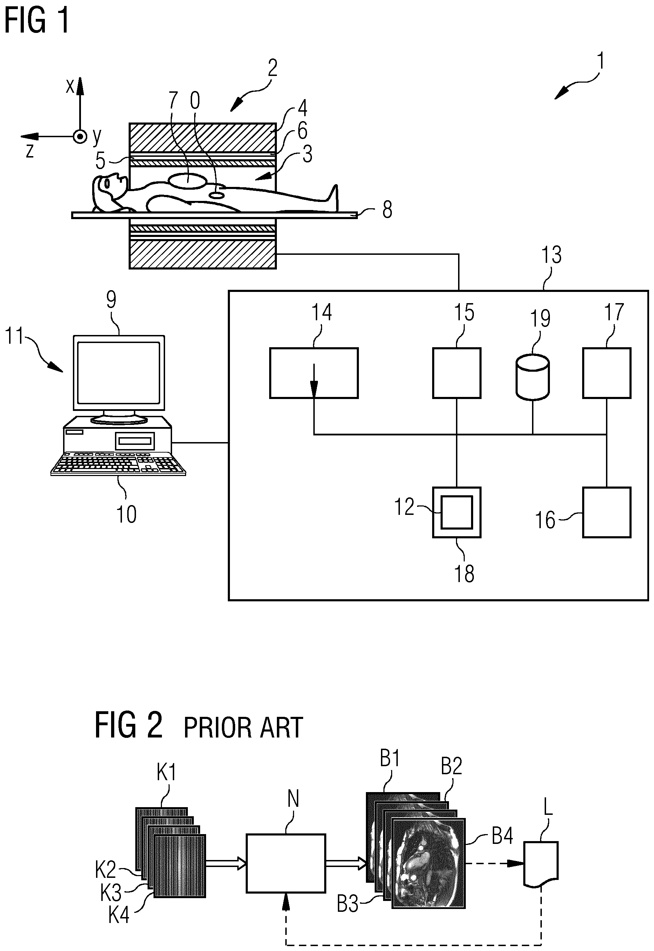

Figure 1 shows a schematic representation of a magnetic resonance imaging system 1 ("MRI-system"). The MRI system 1 includes the actual magnetic resonance scanner (data acquisition unit) 2 with an examination space 3 or patient tunnel in which a patient or test person is positioned on a driven bed 8, in whose body the actual examination object is located.

The magnetic resonance scanner 2 is typically equipped with a basic field magnet system 4, a gradient system 6 as well as an RF transmission antenna system 5 and an RF reception antenna system 7. In the shown exemplary embodiment, the RF transmission antenna system 5 is a whole-body coil permanently installed in the magnetic resonance scanner 2, in contrast to which the RF reception antenna system 7 is formed as local coils (symbolized here by only a single local coil) to be arranged on the patient or test subject. In principle, however, the whole-body coil can also be used as an RF reception antenna system, and the local coils can respectively be switched into different operating modes.

The basic field magnet system 4 here is designed in a typical manner so that it generates a basic magnetic field in the longitudinal direction of the patient, i.e. along the longitudinal axis of the magnetic resonance scanner 2 that proceeds in the z-direction. The gradient system 6 typically includes individually controllable gradient coils in order to be able to switch (activate) gradients in the x-direction, y-direction or z-direction independently of one another.

The MRI system 1 shown here is a whole-body system with a patient tunnel into which a patient can be completely introduced. However, in principle the invention can also be used at other MRI systems, for example with a laterally open, C-shaped housing, as well as in smaller magnetic resonance scanners in which only one body part can be positioned.

Furthermore, the MRI system 1 has a central control device 13 that is used to control the MRI system 1. This central control device 13 includes a sequence control unit 14 for measurement sequence control. With this sequence control unit 14, the series of radio-frequency pulses (RF pulses) and gradient pulses can be controlled depending on a selected pulse sequence or, respectively, a series of multiple pulse sequence to acquire magnetic resonance images within a measurement session. For example, such a series of pulse sequence can be predetermined within a measurement or control protocol. Different control protocols for different measurements or measurement sessions are typically stored in a memory 19 and can be selected by and operator (and possibly modified as necessary) and then be used to implement the measurement.

To output the individual RF pulses of a pulse sequence, the central control device 13 has a radio-frequency transmission device 15 that generates and amplifies the RF pulses and feeds them into the RF transmission antenna system 5 via a suitable interface (not shown in detail). To control the gradient coils of the gradient system 6, the control device 13 has a gradient system interface 16. The sequence control unit 14 communicates in a suitable manner with the radio-frequency transmission device 15 and the gradient system interface 16 to emit the pulse sequence.

Moreover, the control device 13 has a radio-frequency reception device 17 (likewise communicating with the sequence control unit 14 in a suitable manner) in order to acquire magnetic resonance signals (i.e. raw data) for the individual measurements, which magnetic resonance signals are received in a coordinated manner from the RF reception antenna system 7 within the scope of the pulse sequence.

A reconstruction unit 18 receives the acquired raw data and reconstructs magnetic resonance image data therefrom for the measurements. This reconstruction is typically performed on the basis of parameters that may be specified in the respective measurement or control protocol. For example, the image data can then be stored in a memory 19.

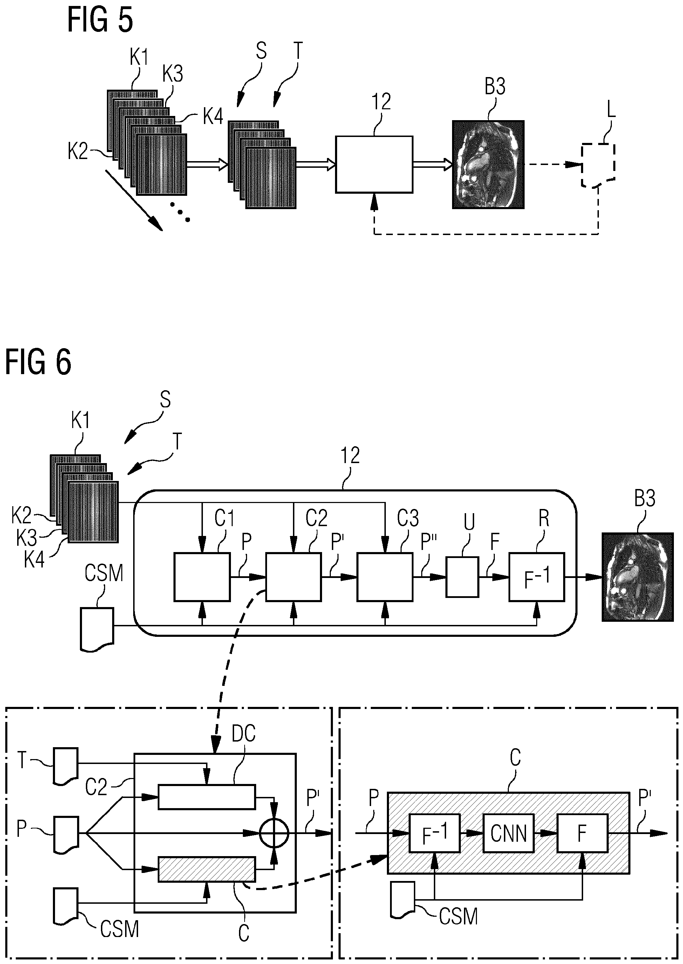

The reconstruction unit 18 comprises a trained reconstruction network 12 as e.g. shown in figure 6.

Operation of the central control device 13 can take place via a terminal 10 with an input unit and a display unit 9, via which the entire MRI system 1 can thus also be operated by an operator. MR images can also be displayed at the display unit 9, and measurements can be planned and started by means of the input unit (possibly in combination with the display unit 9), and in particular suitable control protocols can be selected (and possibly modified) with suitable series of pulse sequence PS as explained above.

The MRI system 1 according to the invention, and in particular the control device 13, can have a number of additional components that are not shown in detail but are typically present at such systems, for example a network interface in order to connect the entire system with a network and be able to exchange raw data and/or image data or, respectively, parameter maps, but also additional data (for example patientrelevant data or control protocols).

The manner by which suitable raw data are acquired by radiation of RF pulses and the generation of gradient fields, and MR images are reconstructed from the raw data, is known to those skilled in the art and thus need not be explained in detail herein.

Figure 2 shows a training procedure of the state of the art. At first, a plurality of N MRI dataframes K1, K2, K3, K4 is recorded from a region of interest at different points of time. Then, the stack is inputted into the neural network N to be trained. This neural network N reconstructs N images B1, B2, B3, B4. For training, a loss is calculated for all reconstructed images B1, B2, B3, B4 and the neural network N is updated based on this loss L.

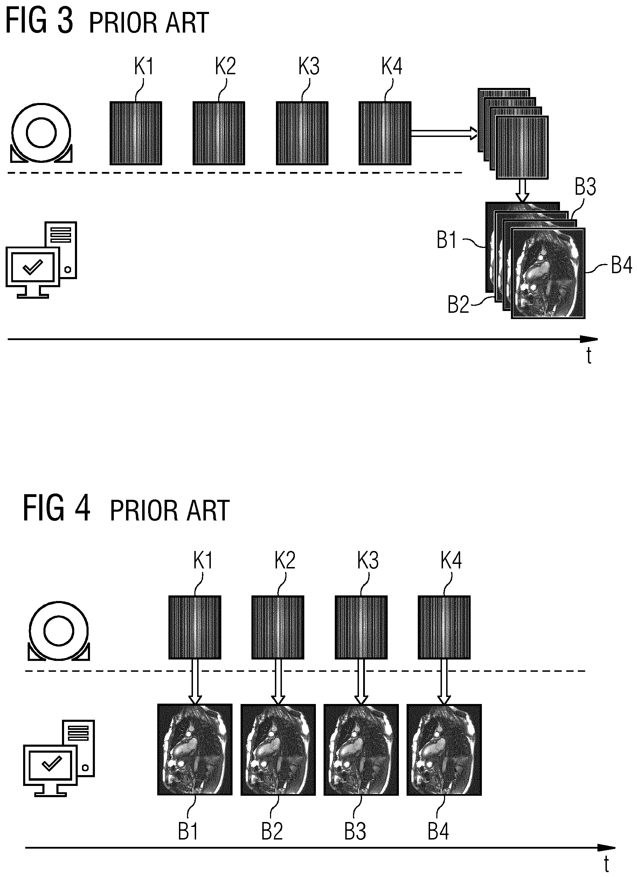

Figure 3 shows a reconstruction procedure of the state of the art. Here, as shown in figure 2, MRI datasets K1, K2, K3, K4 being k-space data K1, K2, K3, K4 are recorded, a stack is produced and all images B1, B2, B3, B4 are reconstructed from this stack.

Figure 4 shows a reconstruction procedure of the state of the art. Here, in contrast to figure 3, MRI datasets K1, K2, K3, K4 being k-space data K1, K2, K3, K4 are recorded and an image B1, B2, B3, B4 of every MRI dataset K1, K2, K3, K4 is reconstructed just after recording.

Figure 5 shows a training-method as well as a reconstruction-method according to the invention. The difference between training and reconstruction is that during training a loss L is produced and the parameters of the reconstruction network are updated (dashed arrow).

At first, a plurality of MRI dataframes K1, K2, K3, K4 is recorded from a region of interest at different points of time, especially from a heart. For training, stored datasets could be used, for clinical application, actually recorded frames should be used, at least when it is intended to show a "real-time" video.

From these MRI datasets K1, K2, K3, K4, a stack of frames is formed. For training, this is the training-stack T (the frames could artificially be under-sampled), for application it is the input stack S. Training-stack T and input stack S should comprise the same number of frames. Regarding a "real-time" video, the input stack S should comprise the temporally last recorded N MRI dataframes K1, K2, K3, K4. Regarding training it is only necessary that there are temporally consecutive frames.

Then, the stack is inputted into the reconstruction network 12.

For application, there is a reconstruction step, wherein an image B3 is reconstructed from a single frame of the input stack S. For training, this image B3 may be reconstructed from a single frame of the training-stack T, as well (as shown in this example), however, also pure k-space data could be used without any reconstruction.

This procedure is then repeated. For application, the reconstructed image B3 is displayed wherein due to displaying the actual image for many repetitions, a user may see a "real-time" video of the displayed images.

For training (following the dashed branch), the loss is calculated and the parameters of the reconstruction network are updated.

Figure 6 shows a reconstruction network 12 for reconstructing cine MRI images according to the invention. The reconstruction network 12 is a variational network designed for reconstructing images from cine MRI data and trained with a training-method according to figure 5.

The reconstruction network comprises an architecture with a cascade of (in this example) three serially arranged cascade-modules C1, C2, C3 each resembling one update step in an iterative gradient descent-based reconstruction. These three cascade-modules C1, C2, C3 each produce an output P, P', P" from an input T, P, P' and are followed by a selection unit U, receiving the output P" of the last cascade-module C3 and selecting one single frame F and an image reconstruction-module R, reconstructing an image B3 based on the selected single frame F (here always the third frame).

The input of the first cascade-module C1, C2, C3 is the subset of the training-frames T selected from the MRI dataset K1, K2, K3, K4 for training and the input data S from the MRI dataset K1, K2, K3, K4 for actual reconstruction work.

In this example, the input of each following cascade-module C1, C2, C3 is the subset of the training-frames T (upper arrows), the output P, P' of the preceding cascade-module C1, C2 (center arrows) and also coil sensitivity maps (lower arrows). In this example the cascade modules have identical internal architectures as shown at the bottom, but different weighting factors and/or computing parameters.

As shown, each cascade-module C1, C2, C3 comprises a convolutional neural network CNN designed to create output images from input images, especially a U-net or a V-net. This convolutional neural network CNN gets its input data from a module (could be a reconstruction module R) generating images from k-space. Its output is back-transferred into k-space again by another module. Additionally, each cascade-module C1, C2, C3 comprises a data consistency module DC working parallel to the convolutional neural network CNN, wherein the outputs of the data consistency module DC and the convolutional neural network CNN are combined, especially together with the input.

A practical approach with a network of figure 6 and a method of figure 5 could be as follows: Fully sampled segmented cine acquisitions from an OCMR dataset (multi coil k-space data from fully sampled cardiac cine series) are retrospectively under-sampled by a factor of eight for constructing a training-dataset. For simulation of Interactive real-time MRI, the "sliding window" approach of the method is chosen, where a subset of eleven consecutive frames from one slice were reconstructed at a time. The loss was then computed on the i-th frame (e.g. the last or the third last) and propagated back into the network for optimization, where N is the size of the sliding window (here 11) and i ∈ [0, N[. Choosing not the last frame increases the latency but allows the network to not only rely on past information for reconstruction.

Although the present invention has been disclosed in the form of preferred embodiments and variations thereon, it will be understood that numerous additional modifications and variations could be made thereto without departing from the scope of the invention. For the sake of clarity, it is to be understood that the use of "a" or "an" throughout this application does not exclude a plurality, and "comprising" does not exclude other steps or elements. The expression "a number of" means "at least one". The mention of a "unit" or a "device" does not preclude the use of more than one unit or device. The expression "a number of" has to be understood as "at least one". Independent of the grammatical term usage, individuals with male, female or other gender identities are included within the term.

## Claims

1. A reconstruction network (12) for reconstructing cine MRI images, the reconstruction network (12) being a variational network designed for reconstructing images from cine MRI data and comprising an architecture with a cascade of cascade-modules (C1, C2, C3), wherein the input of the first cascade-module (C1, C2, C3) is an input-stack (S) of a plurality of N frames (K1, K2, K, K4) and the input of each following cascade-module (C1, C2, C3) is the input-stack (S) and an output-stack (P, P') of the preceding cascade-module (C1, C2), wherein the reconstruction network (12) comprises a selection-unit (U) designed to select one single frame (F) being processed by the cascade-modules (C1, C2, C3) that corresponds to the i-th frame of the input stack (S) for being the basis for the output dataset.

2. The reconstruction network according to claim 1, wherein each cascade-module (C1, C2, C3) comprises a convolutional neural network (CNN) designed to create output images from input images, especially a U-net or a V-net, these images are processed by the convolutional neural network (CNN), especially by using a temporal and/or spatial convolution, and are converted into k-space frames afterwards, preferably wherein each cascade-module (C1, C2, C3) additionally comprises a data consistency module (DC) working parallel to the convolutional neural network (CNN), wherein the outputs of the data consistency module (DC) and the convolutional neural network (CNN) are combined, especially together with the input.

3. The reconstruction network according to claim 1 or 2, comprising an image reconstruction-module (R), arranged to receive the selected single frame (F) of the selection unit (U) and reconstructing an image (B3) based on the selected single frame (F) and/or a loss-module arranged to receive the selected single frame (F) of the selection unit (U) and a reference frame and calculating a loss (L) based on a comparison between data based on the selected single frame (F) and on the reference frame.

4. The reconstruction network according to one of the preceding claims, trained according to the following steps:
a) recording a plurality of MRI dataframes (K1, K2, K3, K4) in a time period, wherein the MRI dataframes (K1, K2, K3, K4) show a region of interest at different points of time,
b) selecting a subset of N training-frames (T) consecutive in time from the MRI dataframes (K1, K2, K3, K4) as input-stack (S),
c) inputting the subset of training-frames (T) into the reconstruction network (12) and generating an output dataset (B3) based on one single frame (F) chosen by the selection-unit (U) of the reconstruction network,
d) computing the loss (L) based on the output dataset (B3) and update the parameters of the reconstruction network (12) based on this loss (L),
e) selecting a further subset of N training-frames (T) consecutive in time from the MRI dataframes (K1, K2, K3, K4),
f) repeating the steps c) to f) until a termination condition is reached.

5. A reconstruction-method for reconstructing cine MRI images with a reconstruction network (12) according to one of the preceding claims, comprising the steps:
a) recording a plurality of MRI dataframes (K1, K2, K3, K4) from a region of interest at different points of time, especially from a heart,
b) form an input stack (S) from the temporally last recorded plurality of N MRI dataframes (K1, K2, K3, K4),
c) inputting the input-stack (S) into the reconstruction network (12) and reconstructing an image (B3) from one single frame (F) chosen by the selection-unit (U) of the reconstruction network (12),
d) displaying the image (B3),
e) in the case there is another recorded MRI dataframe (K1, K2, K3, K4), repeating the steps b) to e) until a termination condition is reached.

6. A training-method for training a reconstruction network according to one of claims 1 to 4, comprising the steps:
a) recording a plurality of MRI dataframes (K1, K2, K3, K4) in a time period, wherein the MRI dataframes (K1, K2, K3, K4) show a region of interest at different points of time,
b) selecting a subset of N training-frames (T) consecutive in time from the MRI dataframes (K1, K2, K3, K4) as input-stack (S),
c) inputting the subset of training-frames (T) into the reconstruction network (12) and generating an output dataset (B3) based on one single frame (F) chosen by the selection-unit (U) of the reconstruction network (12),
d) computing the loss (L) based on the output dataset (B3) and update the parameters of the reconstruction network (12) based on this loss (L),
e) selecting a further subset of N training-frames (T) consecutive in time from the MRI dataframes (K1, K2, K3, K4),
f) repeating the steps c) to f) until a termination condition is reached.

7. The training-method according to claim 6, wherein the MRI dataframes (K1, K2, K3, K4) are processed to be under-sampled by a predefined factor F and the subset of training-frames (T) is selected from the under-sampled MRI dataframes (K1, K2, K3, K4),
preferably wherein a temporally varying under-sampling pattern is used for each frame.

8. The training-method according to claim 6 or 7, wherein for the subset of N training-frames, N is bigger than 4 and/or less than 30, preferably wherein N is selected between 7 and 14.

9. The training-method according to one of claims 6 to 8, wherein every selected single frame has the same relative position in the respective subset of training-frames (T), preferably wherein it is a training-frame from the temporally last third of the subset of training-frames (T), preferably wherein there are not more than 5 training-frames temporally following the training-frame corresponding to the selected single frame (F), especially wherein the selected single frame (F) corresponds to the newest training-frame in the subsample.

10. The training-method according to one of claims 6 to 9, wherein the first selected subset of training-frames (T) starts with a frame of the MRI dataframes (K1, K2, K3, K4), and following subsets of training-frames (T) start with the second frame of the respective preceding subset of training-frames (T).

11. The training-method according to one of claims 6 to 10, wherein the reconstruction unit (12) comprises a reconstruction module (R) designed to reconstruct an image (B3) from a selected single frame (F), wherein the loss (L) is computed based on a comparison between a reconstructed image of the MRI dataframes (K1, K2, K3, K4) and the image (B3) reconstructed based on a respective single frame (F).

12. MRI-System (1) comprising a reconstruction network (12) according to one of the claims 1 to 4, especially trained by a training-method according to one of claims 6 to 11.

13. MRI-System according to claim 12, comprising multiple reconstruction networks (12) according to one of the claims 1 to 4, with selection units (U) designed to select single frames (F) at different positions of processed stacks (P"), wherein each reconstruction network (12) comprises a selection unit (U) selecting single frames (F) at an individual constant position of processed stacks (P"), preferably wherein the MRI-System (1) additionally comprises a user interface (11) designed such that a user is able to choose between the positions of the selected single frames (F), especially by choosing between given positions or between given latency times.

14. A computer program product comprising instructions which, when the program is executed by a computer, cause the computer to carry out the steps of the training-method of any of claims 6 to 11 or of the reconstruction-method according to claim 5.

15. A computer-readable storage medium comprising instructions which, when executed by a computer, cause the computer to carry out the steps of the training-method of any of claims 6 to 11 or of the reconstruction-method according to claim 5.
